**Europäisches Patentamt**

**European Patent Office**

**Office européen des brevets**

(19)

(11) Veröffentlichungsnummer: **0 253 225**
**B1**

(12) EUROPÄISCHE PATENTSCHRIFT

(45) Veröffentlichungstag der Patentschrift:
28.03.90

(51) Int. Cl.⁴: **G04G 1/00**, H05K 1/18

(21) Anmeldenummer: 87109560.0

(22) Anmeldetag: 03.07.87

(54) Verfahren zum Bestücken eines Leiterbahnen-Netzwerks für den Schaltungsträger eines elektromechanischen Uhrwerks und teilbestücktes Leiterbahnen-Netzwerk eines Uhrwerks-Schaltungsträgers.

(30) Priorität: 11.07.86 DE 3623419

(43) Veröffentlichungstag der Anmeldung:
20.01.88 Patentblatt 88/3

(45) Bekanntmachung des Hinweises auf die Patenterteilung:
28.03.90 Patentblatt 90/13

(84) Benannte Vertragsstaaten:
CH DE ES FR GB IT LI NL

(56) Entgegenhaltungen:
EP-A- 0 009 135
CH-A- 621 667
FR-A- 2 390 008
US-A- 3 287 795
US-A- 4 042 861

PATENT ABSTRACTS OF JAPAN, Band 9,
Nr. 244 (E-346)[1967], 30. September 1985; &
JP-A-60 94 746
PATENT ABSTRACTS OF JAPAN, Band 8,
Nr. 99 (E-243)[1536], 10. Mai 1984; & JP-A-59 17 274

(73) Patentinhaber: JUNGHANS UHREN GMBH,
Geisshaldenstrasse, D-7230 Schramberg(DE)

(72) Erfinder: Holzschuh, Wolfgang, Siebenlinden 2,
D-7233 Lauterbach(DE)
Erfinder: Ganter, Wolfgang, Heiligenbronnerstrasse 52,
D-7230 Schramberg(DE)

(74) Vertreter: Hofmann, Gerhard, Dipl.-Ing. Patentassessor,
Stephanstrasse 49, D-8500 Nürnberg(DE)

ACTORUM AG

## Beschreibung

Die Erfindung betrifft ein Verfahren gemäß dem Oberbegriff des Anspruches 1 und ein Netzwerk gemäß dem Oberbegriff des Anspruches 6.

Die gattungsgemäßen Maßnahmen sind aus der DE-OS 26 19 833, dort in Zusammenhang mit Fig. 2, bekannt. Insbesondere ist im vorliegenden Zusammenhang aber an ein Leiterbahnen-Netzwerk für einen Schaltungsträger gedacht, wie er im eigenen DE-C 3 427 908 näher beschrieben ist.

Nach der DE-OS 26 19 833 ist vorgesehen, den Schaltkreis (Chip) auf dem aus einem Träger-Band herausgeschnittenen Leiterbahnen-Netzwerk zu befestigen und zu bonden; woraufhin dieses so vorbestückte Netzwerk auf der isolierenden Unterlage einer Schaltungsträger-Platine des Uhrwerks festgelegt wird. Schließlich werden aus mechanischen Stabilitätsgründen noch verbliebene Brücken zwischen den Netzwerk-Leiterbahnen, insoweit es für die elektrische Funktion der Schaltung erforderlich ist, aufgetrennt und dann der Chip eingegossen. Damit sind aber erhebliche Einschränkungen hinsichtlich der Handhabbarkeit und auch hinsichtlich der Leiterbahnen-Konfiguration gegeben.

Denn der gegen mechanische Beanspruchungen besonders kritische Umgebungsbereich der Bond-Verdrahtung zwischen dem Schaltkreis und benachbarten Leiterbahnen erfährt sowohl während des Einsetzens des Netzwerkes in den Schaltungsträger wie auch während des Aufstanzens der verbliebenen Brücken erhebliche mechanische Beanspruchungen, die zu funktionellen Störungen der Bondverbindungen und damit später des gesamten elektromechanischen Uhrwerks führen können.

In Erkenntnis dieser Gegebenheiten liegt der Erfindung die Aufgabe zugrunde, die gattungsgemäßen Maßnahmen dahingehend weiterzubilden, daß die fertigungstechnischen Komplikationen und funktionellen Risiken in Zusammenhang mit der Bestückung eines Schaltungsträgers mit vorbestückten Leiterbahnen-Netzwerken verringert werden und damit der fertigungstechnische Aufwand für den Aufbau von Großuhren-Werken noch weiter reduziert werden kann.

Diese Aufgabe wird erfindungsgemäß im wesentlichen dadurch gelöst, daß bei den gattungsgemäßen Maßnahmen jeweils der Kennzeichnungsteil des Anspruches 1 bzw. des Anspruches 6 realisiert ist.

Nach dieser Lösung erfolgt das Auftrennen des Netzwerkes zu den elektrisch-funktionell notwendigen einzelnen Leiterbahnen in der Umgebung des Schaltkreises bereits vor dem Bonden des Schaltkreises und insbesondere auch bereits vor dem Aufbringen des Netzwerkes auf seine Schaltungsträger-Platine. Dadurch ist sichergestellt, daß Chips nur auf Netzwerke aufgebracht und verbondet werden, die mechanisch-geometrisch ihren Endzustand aufweisen und z.B. bereits einer entsprechenden Qualitätsprüfung (etwa im Wege der Schattenriß-Bildverarbeitung) unterzogen werden konnten, so daß von vornherein ausgeschlossen werden kann, mechanisch unbrauchbare Netzwerke mit den kostspieligen Schaltkreis-Chips und Bondverbindungen zu versehen.

Nachdem die einzelnen noch zum Band zusammengefügten Netzwerke mit gebondeten Schaltkreisen bestückt sind, erfahren sie eine mechanische Versteifung und einen Schutz ihrer Anschlußoberflächen und Bondverbindungen durch Überstülpen einer kraftschlüssig an den Netzwerk-Leiterbahnen befestigbaren Haube, die dadurch zugleich eine mechanische Verbindung zwischen einzelnen der zu den Bonddrähten führenden Leiterbahnen-Enden darstellt und aufgrund dieser Versteifungswirkung mechanischen Beschädigungen der Bond-Verbindungen infolge mechanischer Biegebeanspruchungen der Leiterbahnenenden bei der weiteren Bearbeitung des Netzwerk-Bandes entgegenwirkt.

Abdeckhauben für Chips, insbesondere für Uhrenschaltkreise, sind an sich bekannt (siehe z.B. US-A 4 042 861).

Ein zusätzlicher mechanischer Schutz des Netzwerks in der Umgebung des aufgeklebten und verbondeten Schaltkreises wird vorliegend dadurch erzielt, daß das Innere der aufgestülpten Haube mit einer Vergußmasse ausgespritzt wird, die nach dem Erkalten den Schaltkreis und die Bonddrähte auf der zugewandten Oberfläche der Leiterbahnen innig umgibt, also zur mechanischen Versteifung des Gesamtgebildes und zum Schutz gegen Umwelteinflüsse beiträgt. Vorzugsweise wird in die Öffnung der Haube so viel Vergußmasse eingegeben, daß die Leiterbahnen auch auf der vom Schaltkreis und den Bondverbindungen abgewandten Seite mit erstarrender Vergußmasse umgeben sind, also längs ihrer Oberflächen und Ränder von der erstarrenden Vergußmasse eingefaßt und damit in ihrer relativen Orientierung fixiert werden.

Zusätzliche Alternativen und Weiterbildungen sowie weitere Merkmale und Vorteile der Erfindung ergeben sich aus den weiteren Ansprüchen und aus nachstehender Beschreibung eines in der Zeichnung unter Beschränkung auf das Wesentliche abstrahiert aber angenähert maßstabsgerecht stark vergrößert skizzierten bevorzugten Realisierungsbeispiels zur erfindungsgemäßen Lösung. Es zeigt:

Fig. 1 einen mit einem Schaltkreis bestückten Ausschnitt aus einem Leiterbahnen-Netzwerk gemäß der Schnitt-Sichtlinienangabe I-I in Fig. 2 aber vor Ausgießen des Hauben-Innenraumes mit Vergußmasse, **und**

Fig. 2 eine Schnittdarstellung gemäß der Schnittlinienangabe II-II in Fig. 1 nach dem Ausgießen des Hauben-Innenraumes mit Vergußmasse.

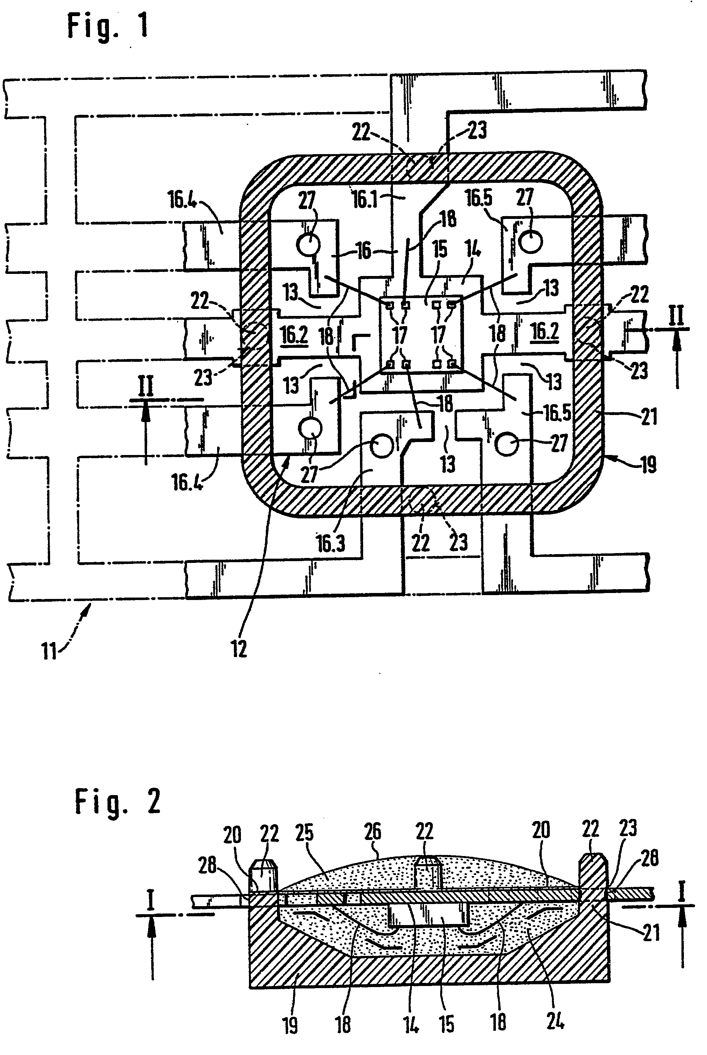

Bei einem Band 11 aus einer Folge von zunächst noch zusammenhängenden Leiterbahnen-Netzwerken 12 werden zunächst Freistanzungen 13 in der Umgebung der Montagefläche 14 für einen integrierten Schaltkreis 15 (als zunächst noch ungebondeten Halbleiter-Chip) vorgenommen, sofern diese Freistanzungen 13 nicht bereits beim Ausstanzen des vorgegebenen Blechstreifens zum Netzwerk-Band 11 mitrealisiert wurden. Die Montagefläche 14 ist Teil wenigstens einer Leiterbahn 16 des Netzwerks 12, die außer mechanischer Halterungsfunktion auch elektrische Funktion haben kann; so ist im dargestellten Ausführungsbeispiel nach Fig. 1 die Montagefläche 14 einstückig mit der Leiterbahn 16.1 für die positive Spannungsversorgung des Schaltkreises 15 und gleichzeitig einstückig mit elektrisch nicht benötigten, allein der mechanischen Halterung dienenden Leiterbahnen 16.2 ausgebildet. Für die Funktion des Schaltkreises 15 benötigte Anschlußflächen 17 des Schaltkreises 15 sind über Bonddrähte 18 elektrisch an funktionell zugeordnete Leiterbahnen 16 angeschlossen; so an die schon erwähnte Leiterbahn 16.1 für die positive Stromversorgung, darüberhinaus im dargestellten Beispielsfalle an Leiterbahnen 16.3, 16.4 und 16.5 für die gegenpolige Stromversorgung, für den Oszillatoranschluß und für den Motoranschluß eines elektromechanischen Uhrwerks.

Die Bonddrähte 18 werden direkt mit den einzelnen Netzwerken 12 verbunden, nachdem der Schaltkreis 15 auf die Montagefläche 14 aufgeklebt ist.

Nach dieser mechanischen Festlegung samt elektrischem Anschluß des Schaltkreises 15 am Netzwerk 12 wird eine im Kunststoff-Spritzguß vorgefertigte Schutz-Haube 19 über den Schaltkreis 15 und die ihn umgebenden Anschluß-Endbereiche der Leiterbahnen 16 gestülpt. Diese ruht (zunächst) mit dem Stirnrand 20 ihrer Seitenwände 21 auf der Oberfläche der Leiterbahnen 16; wobei über die Ebene des Stirnrandes 20 vorragende angeformte Zapfen 22 in Löcher 23 eingreifen, die in wenigstens einige der Leiterbahnen 16 eingestanzt sind. In Fig. 1 ist berücksichtigt, daß es durchaus bei einer geometrischen Konstellation des Verlaufes der Leiterbahnen 16 vorkommen kann, daß für einen der Zapfen 22 kein Halterungs-Loch 23 verfügbar ist. Vorzugsweise ist ein kraftschlüssiger Halt der Zapfen 22 in zugeordneten Löchern 23 vorgesehen, wofür leicht konisch zugespitzt verlaufende Zapfen 22 in die Löcher 23 eingepreßt werden.

Zum weiteren Schutz des Schaltkreises 15 und seiner Bonddrähte 18 sowie zur weiteren mechanischen Sicherung dieser Anordnung unter gleichzeitiger Versteifung des Netzwerks 12 in der Umgebung der Montagestelle des Schaltkreises 15 ist vorgesehen, nach der Montage des Schaltkreises 15 und Aufsetzen der Haube 19 diese Anordnung umzuwenden, so daß (siehe Fig. 2) der Innenraum 24 der kraftschlüssig nun unter dem Netzwerk 12 gehalterten Haube 19 sich nach oben, zum Netzwerk 12 hin öffnet. In diesen Innenraum 24 wird durch die Freistanzungen 13 des Netzwerkes 12 hindurch eine Kunststoff-Vergußmasse 25 im flüssigen Aggregatzustand eingefüllt, die dann nach Ausfüllung aller Freiräume darin erstarrt und somit einen mechanischen Schutz des nun gekapselten, verbondeten Schaltkreis 15 ergibt; wie es insoweit aus dem Einguß von Schaltkreisen mit Leadframe als solches bekannt ist.

Für eine gute Haftung der Vergußmasse und damit für eine gute mechanische Stabilität des Netzwerkes 12 in der Umgebung des Schaltkreises 15 wird (wie in Fig. 2 berücksichtigt) vorzugsweise nicht nur der Innenraum 24 mit Vergußmasse 25 gefüllt, sondern die Oberflächenspannung der zunächst dünnflüssigen Vergußmasse 25 zur Ausbildung eines Hügels 26 auf der vom Schaltkreis 15 abgelegenen Seite der Leiterbahnen 16 ausgenutzt. Im Interesse einer beständigen formschlüssigen Verbindung der Vergußmasse 25 auf beiden Seiten der Leiterbahnen 16 weisen diese vorzugsweise Durchtrittsöffnungen 27 (siehe Fig. 1) auf, so daß die Leiterbahnen 16 nicht nur längs ihrer Seitenränder, sondern auch im jeweiligen Innenbereich von Vergußmasse 25 eingefaßt sind.

Damit bei Ausbildung des Hügels 26 nicht die zunächst dünnflüssige Vergußmasse 25 über die Peripherie der Hauben-Seitenwände 21 seitlich längs Leiterbahnen-Zwischenräumen austritt (und dadurch z.B. später des Abtrennen des Netzwerkes 12 aus dem Band 11 bzw. das Einbetten des abgetrennten Netzwerkes 12 in eine Uhrwerks-Schaltungsträgerplatte behindert), ist es zweckmäßig, die Seitenwände 21 der Haube 19 nicht nur auf die zugewandte Oberfläche der Leiterbahnen 16 aufzulegen, sondern etwas in diese einzudrücken. Das kann unter Energiezufuhr wie Wärmezufuhr oder insbesondere unter Ultraschalleinwirkung erfolgen. Jedenfalls werden dadurch die Leiterbahnen 16 in die ursprüngliche Ebene des Stirnrandes 20 hineingedrückt, bis in den Zwischenräumen zwischen den Leiterbahnen 16 dieser Stirnrand 20 über die gegenüberliegende Oberfläche der Leiterbahnen 16 vorragt; wie in Fig. 2 durch den seitlichen Absatz 28 veranschaulicht. Dadurch wird bewirkt, daß der Hauben-Innerraum 24 auch jenseits der Leiterbahnen 16. also auf der Seite, auf der der Hügel 26 ausgebildet werden soll, eine geringfügig über die Leiterbahnen 16 überstehende Berandung aufweist, so daß beim Einfüllen der zunächst flüssigen Vergußmasse 25 diese nicht zwischen den Leiterbahnen 16 aus dem Bereiche der Haube 19 seitlich ausläuft sondern nur die Leiterbahnen 16 längs ihrer Ränder und Durchtrittsöffnungen 27 innig einschließt.

Das so mit dem Schaltkreis 15 bestückte und mechanisch gesicherte Netzwerk 12 kann dann aus dem Band 11 ausgestanzt und in einen entsprechend profilierten Schaltungsträger eines Uhrwerks eingelegt werden, wie im einzelnen im Patent DE-C 3 427 908 für ein bevorzugtes Realisierungsbeispiel eines Schaltungsträgers näher beschrieben.

**Patentansprüche**

1. Verfahren zum Bestücken eines Leiterbahnen-Netzwerkes mit integriertem Schaltkreis, für den Schaltungsträger eines elektromechanischen Uhrwerkes mit gekapseltem integrierten Schaltkreis, dadurch gekennzeichnet, daß der an das Netzwerk gebondete Schaltkreis einschließlich seiner Bonddrähte, vor dem Heraustrennen aus dem Netzwerk-Band und Befestigen auf dem Schaltungsträger, eine starre Schutz-Haube übergestülpt erhält, die am Netzwerk festgelegt wird.

2. Verfahren nach Anspruch 1, dadurch gekennzeichnet, daß die Haube unter Verformung ihres Stirnrandes in die Lücken zwischen den Leiterbahnen des Netzwerkes eingepreßt wird.

3. Verfahren nach Anspruch 1 oder 2, dadurch gekennzeichnet, daß der Innenraum der Haube mit einer aushärtenden Vergußmasse gefüllt wird.

4. Verfahren nach Anspruch 3, dadurch gekennzeichnet, daß die Vergußmasse in die Haube eingefüllt wird, nachdem das Netzwerk umgedreht wurde, um die Haube nach oben zu öffnen.

5. Verfahren nach einem der vorangehenden Ansprüche, dadurch gekennzeichnet, daß der Hauben-Innenraum, einschließlich eines darüberliegenden Raumbereiches auf der gegenüberliegenden Seite der Leiterbahnen, mit Vergußmasse aufgefüllt wird.

6. Teilbestücktes Leiterbahnen-Netzwerk (12) für den Schaltungsträger eines elektromechanischen Uhrwerks,mit auf dem Netzwerk (12) verbondet und umhüllt angeordnetem Schaltkreis (15), hergestellt nach dem Verfahren nach Patentanspruch 1, dadurch gekennzeichnet, daß der Schaltkreis (15) einschließlich seiner Bonddrähte (18) von einer auf Netzwerk-Leiterbahnen (16) befestigten Haube (19) überdeckt ist.

7. Netzwerk nach Anspruch 6, dadurch gekennzeichnet, daß die Haube (19) mit über den Stirnrand (20) ihrer Seitenwände (21) vorstehenden Zapfen (22) kraftschlüssig in Löchern (23) gehaltert ist, die in Leiterbahnen (16) des Netzwerkes (12) ausgespart sind.

8. Netzwerk nach Anspruch 6 oder 7, dadurch gekennzeichnet, daß der Seitenwand-Stirnrand (20) der Haube (19) in Zwischenräume zwischen den Netzwerk-Leiterbahnen (17), diese überragend, eingreift.

9. Netzwerk nach einem der Ansprüche 6 bis 8, dadurch gekennzeichnet, daß der Hauben-Innenraum (24) mit Vergußmasse (25) ausgefüllt ist.

10. Netzwerk nach einem der Ansprüch 6 bis 9, dadurch gekennzeichnet, daß der Hauben-Innenraum (24) einschließlich eines Hügels (26) auf der gegenüberliegenden Seite der Netzwerk-Leiterbahnen (16) mit Vergußmasse (25) ausgefüllt ist.

## Claims

1. A method of equipping a conductor-path network having an integrated circuit, for the circuit carrier of an electro-mechanical clock-work having an encased integrated circuit, characterised in that the circuit bonded onto the network including its bond wires, prior to the separation from the network-band and fastening on the circuit carrier, is covered over with a rigid protective hood which is secured to the network.

2. A method according to Claim 1, characterised in that the hood is pressed along with deformation of its front edge into the gaps between the conductor paths of the network.

3. A method according to Claim 1 or 2, characterised in that the interior of the hood is filled with a hardening casting compound.

4. A method according to Claim, characterised in that the casting compound is filled into the hood after the network has been turned around, in order to open the hood upwardly.

5. A method according to one of the preceding claims, characterised in that the hood interior, including a space region lying thereabove on the opposite side of the conductor paths, is filled up with casting compound.

6. A partly-equipped conductor-path network (12) for the circuit carrier of an electro-mechanical clock-work, having a circuit (15) arranged bonded and sheathed on the network (12), produced in accordance with the method according to Claim 1, characterised in that the circuit (15) including its bond wires (18) is covered by a hood (19) fastened on network conductor paths (16).

7. A network according to Claim 6, characterised in that the hood (19) is held with pins (22) protruding beyond the front edge (20) of its side walls (21) in force-locking manner in holes (23) which are hollowed out in conductor paths (16) of the network (12).

8. A network according to Claim 6 or 7, characterised in that the side-wall front edge (20) of the hood (19) engages into interstices between the network conductor paths (17), projecting beyond these.

9. A network according to one of Claims 6 to 8, characterised in that the hood interior (24) is filled up with casting compound (25).

10. A network according to one of Claims 6 to 9, characterised in that the hood interior (24) including a mound (26) on the opposite side of the network conductor paths (16) is filled up with casting compound (25).

## Revendications

1. Procédé pour équiper un réseau de pistes conductrices avec un circuit intégré, pour le support de circuit d'un mécanisme d'horlogerie électromécanique à circuit intégré encapsulé, caractérisé en ce que le circuit lié au réseau, y compris ses fils de connexion, est coiffé, avant la séparation de la bande du réseau et la fixation sur le support de circuit, d'une calotte de protection rigide, que l'on fixe au réseau.

2. Procédé selon la revendication 1, caractérisé en ce qu'on enfonce la calotte dans les interstices entre les pistes conductrices du réseau en déformant son bord frontal.

3. Procédé selon la revendication 1 ou 2, caractérisé en ce qu'on remplit l'intérieur de la calotte d'une masse coulée durcissante.

4. Procédé selon la revendication 3, caractérisé en ce qu'on introduit la masse coulée dans la calotte après avoir retourné le réseau, pour ouvrir la calotte vers le haut.

5. Procédé selon l'une des revendications précédentes, caractérisé en ce qu'on remplit l'intérieur de la calotte, y compris une portion d'espace surjacente du côté opposé des pistes conductrices, de masse coulée.

6. Réseau de pistes conductrices (12) partiellement équipé pour le support de conducteurs d'un mécanisme d'horlogerie électromécanique, comportant un circuit (15) connecté au réseau (12) et encapsulé, obtenu par le procédé selon la revendication 1, caractérisé en ce que le circuit (15), y compris ses fils de connexion (18), est recouvert par une calotte (19) fixée sur des pistes conductrices de réseau (16).

7. Réseau selon la revendication 6, caractérisé en ce que la calotte (19) est fixée à force dans des trous (23) qui sont pratiqués dans des pistes conductrices (16) du réseau (12) au moyen de broches (22) faisant saillie du bord frontal (20) de ses parois latérales (21).

8. Réseau selon la revendication 6 ou 7, caractérisé en ce que le bord frontal (20) de la paroi latérale de la calotte (19) s'engage dans des intervalles entre les pistes conductrices (17) du réseau, en dépassant.

9. Réseau selon l'une des revendications 6 à 8, caractérisé en ce que la cavité intérieure (24) de la calotte est remplie de masse coulée (25).

10. Réseau selon l'une des revendications 6 à 9, caractérisé en ce que la cavité intérieure de la calotte (24) est remplie d'une masse coulée formant également une surépaisseur (26) sur le côté opposé des pistes conductrices (16) du réseau.

# Fig. 1

# Fig. 2